# EUROPEAN PATENT APPLICATION

(11) **EP 4 831 603 A1**
(43) Date of publication of application: **28.10.2026**
(21) Application number: 26173482.6
(22) Date of filing: 20.04.2026
(51) Int. Cl.: G01M 11/00, G01N 21/95

(54) **SYSTEM AND METHOD FOR MITIGATING POSITION-SENSITIVE ERRORS IN PHOTONIC INTEGRATED CIRCUIT TESTING**

(30) Priority: 24.04.2025 US 202563793895 P
(71) Applicant: EXFO Inc., Québec, QC G1M 2K2 (CA)
(72) Inventor: NOEL PARISE, Sammy, Quebec, G1M 2K2 (CA); DUBE-DEMERS, Raphael, Quebec, G1M 2K2 (CA)
(74) Representative: Gregory, Alexandra Louise

(57) **Abstract**

A method and a system for mitigating position-sensitive optical measurement errors during photonic integrated circuit (PIC) testing are disclosed. The system includes a light source, an optical probe, an optical detector, and an alignment stage. The method involves adjusting, with the alignment stage, a gap between the probe and the PIC to *N* ≥ 2 distinct gap settings corresponding to probe-to-PIC distances selected to produce *N* round-trip phase shifts within an optical cavity formed in the gap, the phase shifts being spaced substantially evenly over a full 2*π* cycle. For each gap setting, a test measurement is performed that includes injecting test light from the light source into the PIC via the probe, collecting light output from the PIC via the probe, and detecting the collected light with the detector to generate a measurement result. The *N* measurement results are combined into a corrected measurement result with reduced cavity-induced errors.

## Description

### TECHNICAL FIELD

The technical field pertains to the testing of photonic integrated circuits (PICs), and more specifically, to methods and systems for mitigating position-sensitive optical measurement errors in PIC testing.

### BACKGROUND

Photonic integrated circuits (PICs) are microchips that integrate multiple photonic components onto a common substrate for processing and transmitting information. As PICs play an increasingly important role in optical communication systems, the demand for accurate and high-throughput testing methods has grown. Automated testing stations are commonly used to characterize PIC performance by injecting light into, and collecting light from, a PIC device under test using optical probes (e.g., fiber arrays) and integrated optical couplers. Two primary coupling approaches are employed in PIC testing: surface coupling, where light is introduced out-of-plane through the PIC's top surface, and edge coupling, where light is introduced in-plane through the side of the PIC. Edge coupling is often favored for industrial and high-performance applications due to its lower insertion losses and reduced sensitivity to polarization and wavelength variations. However, edge coupling presents alignment challenges, particularly in wafer-level or high-throughput environments where consistent probe positioning is difficult to maintain.

### SUMMARY

The present description concerns systems and methods designed for mitigating measurement errors caused by position-sensitive, cavity-induced interference effects during PIC testing. The disclosed techniques involve performing multiple test measurements at distinct probe-to-PIC distances, selected to produce phase-opposed interference patterns, which are then combined to substantially attenuate cavity-induced artifacts in the measured signals, thereby reducing the sensitivity of test results to probe-to-PIC gap variations. The disclosed techniques allow for repeatable and accurate characterization of PIC parameters such as insertion loss, return loss, and wavelength-dependent transmission or reflection spectra, including in high-throughput or wafer-level test conditions.

In accordance with an aspect, there is provided a method for mitigating position-sensitive errors during testing of a photonic integrated circuit (PIC), the method including:
providing a testing system including a light source, an optical probe, an optical detector, and an alignment stage;
adjusting, with the alignment stage, a gap between the optical probe and the PIC to N distinct gap settings, wherein *N ≥* 2, the gap settings corresponding to respective probe-to-PIC distances selected to produce N round-trip optical phase shifts for optical propagation within an optical cavity formed in the gap, the round-trip optical phase shifts being spaced substantially evenly in phase over a full 2*π* cycle;
for each of the N distinct gap settings, performing a test measurement including:
   injecting test light from the light source into the PIC via the optical probe;
   collecting measurement light output from the PIC via the optical probe; and
   detecting the collected measurement light with the optical detector to generate a measurement result; and
combining the measurement results from the N test measurements to generate a corrected measurement result with reduced position-sensitive errors induced by the optical cavity.

In some embodiments, the method includes coupling the optical probe with the PIC in an edge-coupled configuration.

In some embodiments, the method includes providing the optical probe as an optical fiber array.

In some embodiments, N= 2, and adjusting the gap between the optical probe and the PIC includes setting the two probe-to-PIC distances to differ by approximately a quarter wavelength of the test light at a design wavelength.

In some embodiments, the measurement results correspond to insertion loss spectra of the PIC, measured at the N gap settings. In some embodiments, the insertion loss spectra are acquired over a waveband that lies within a spectral range from about 1260 nm to about 1680 nm.

In some embodiments, the light source is a tunable laser.

In some embodiments, the method is implemented with the PIC provided in a wafer-level or multi-die test configuration.

In some embodiments, adjusting the gap between the optical probe and the PIC includes moving the optical probe with respect to the PIC.

In some embodiments, adjusting the gap between the optical probe and the PIC includes moving the PIC with respect to the optical probe.

In some embodiments, combining the measurement results includes computing an average of the measurement results from the N test measurements.

In accordance with another aspect, there is provided a testing system for testing a photonic integrated circuit (PIC) with reduced position-sensitive errors, the testing system including:
a light source configured to generate test light;
an optical probe configured to couple the test light from the light source into the PIC and collect measurement light output from the PIC;
an optical detector configured to detect the collected measurement light;
an alignment stage configured to adjust a gap between the optical probe and the PIC to *N* distinct gap settings over a series of N test measurements, wherein *N* ≥ 2, the gap settings corresponding to respective probe-to-PIC distances selected to produce N round-trip optical phase shifts for optical propagation within an optical cavity formed in the gap, the round-trip optical phase shifts being spaced substantially evenly in phase over a full 2*π* cycle; and
a control and processing unit coupled to the optical detector and configured to:
   receive, for each one of the N test measurements, a corresponding measurement result from the optical detector; and
   combine the N measurement results to generate a corrected measurement result with reduced position-sensitive errors induced by the optical cavity.

In some embodiments, the optical probe is configured to couple with the PIC in an edge-coupled configuration.

In some embodiments, the optical probe includes an optical fiber array.

In some embodiments, *N =* 2*,* and the alignment stage is configured to set the two probe-to-PIC distances to differ by approximately a quarter wavelength of the test light at a design wavelength.

In some embodiments, the measurement results correspond to insertion loss spectra of the PIC, measured at the N gap settings. In some embodiments, the optical detector is configured to acquire the insertion loss spectra over a waveband that lies within a spectral range from about 1260 nm to about 1680 nm.

In some embodiments, the light source includes a tunable laser.

In some embodiments, the alignment stage is configured to adjust the gap between the optical probe and the PIC by moving the optical probe with respect to the PIC.

In some embodiments, the alignment stage is configured to adjust the gap between the optical probe and the PIC by moving the PIC with respect to the optical probe.

In some embodiments, the control and processing unit is configured to automatically control the operation of the light source and the alignment stage during the N test measurements.

In some embodiments, the control and processing unit is configured to compute an average of the measurement results from the N test measurements to generate the corrected measurement result.

In some embodiments, the testing system is configured to test the PIC in a wafer-level or multi-die test configuration.

Other method and process steps may be performed before, during, or after the steps described herein. The order of one or more steps may also differ, and some of the steps may be omitted, repeated, or combined, as the case may be. It is also to be noted that some steps may be performed using various analysis and processing techniques, which may be implemented in hardware, software, firmware, or any combination thereof.

Other objects, features, and advantages of the present techniques will become more apparent upon reading of the following non-restrictive description of specific embodiments thereof, given by way of example only with reference to the appended drawings. Although specific features described in the above summary and in the detailed description below may be described with respect to specific embodiments or aspects, it should be noted that these specific features may be combined with one another unless stated otherwise.

### BRIEF DESCRIPTION OF THE DRAWINGS

Figs. 1, 2, and 3A to 3C depict various aspects, features, and implementations of, or related to, the techniques disclosed herein.
Fig. 1 is a schematic representation of a testing system for testing a photonic integrated circuit (PIC), in accordance with one embodiment.
Fig. 2 is a flow diagram of a method for mitigating position-sensitive optical measurement errors during testing of a PIC, in accordance with another embodiment.
Fig. 3A shows four insertion loss spectra acquired at different probe-to-PIC distances using conventional single-point measurements. Fig. 3B shows four insertion loss spectra acquired at different probe-to-PIC distances, each obtained by averaging a pair of single-point spectra measured with complementary phase shift. Fig. 3C shows spectral variation envelopes corresponding to the spectra in Figs. 3A and 3B.

### DETAILED DESCRIPTION

The present disclosure describes methods and systems for mitigating position-sensitive errors during photonic integrated circuit (PIC) testing. The disclosed techniques are designed to reduce the effects of Fabry-Pérot (FP) cavities formed between a test probe and the PIC during edge-coupling measurements.

In a typical test configuration, an optical probe, such as a fiber array, is aligned with the edge couplers of the PIC to facilitate bidirectional optical access. A light source coupled to the optical probe injects test light into the PIC via an input edge coupler. Measurement light exiting the PIC through an output edge coupler is collected by the optical probe and directed to an optical detector for analysis. Due to the separation between the optical probe and the PIC, and the partially reflective nature of the interfaces at both ends of the resulting gap, an FP cavity is formed. This cavity induces interferometric artifacts, such as periodic spectral ripples, in the measured optical signal, which can introduce systematic errors in test results.

Traditional testing methods, such as loopback measurements, provide limited mitigation of these cavity-induced effects. Loopback techniques rely on reference paths and assume consistent insertion losses across edge couplers, but they do not address the underlying sensitivity to probe-to-PIC spacing. While index-matching materials (e.g., gels, glues, or oils) can reduce these interference effects, their use is impractical in high-throughput settings such as wafer-level or multi-die testing. Despite the application of such conventional mitigation techniques, experimental results obtained by the inventors indicate the consistent presence of residual measurement errors on the order of several tenths of a decibel (dB). These errors have been observed to be highly sensitive to the alignment of individual fibers within the probe. Because the errors arise from interferometric effects, even subwavelength variations in the probe-to-PIC gap (e.g., on the order of 100 nm) can produce measurable fluctuations in coupling efficiency, leading to unwanted sensitivity to probe positioning and reduced measurement repeatability.

To address these issues, the present disclosure introduces a complementary N-step measurement technique designed to mitigate measurement errors arising from FP interference in PIC testing. This technique reduces the sensitivity of optical test results to small variations in the probe-to-PIC spacing by systematically adjusting the gap between the probe and the PIC over a series of *N* distinct values, where *N* is an integer equal to or greater than two. These phase shifts are chosen to be spaced substantially evenly over a full 2*π* cycle. When appropriately combined, for example, through averaging or weighted summation, these measurements help mitigate the periodic modulation effects introduced by the cavity, leading to a reduction in spectral ripple artifacts in the resulting test signal.

In the simplest case, where *N* = 2, the gap is set to two values that differ by approximately a quarter of the test light's free-space wavelength, or an odd multiple thereof. This introduces a *π* phase difference in the round-trip interference signal between the two measurements. Since the resulting cavity-induced oscillations are nearly opposite in phase, their combination substantially cancels the oscillatory component, producing a more accurate signal that better represents the PIC's optical response.

Each test cycle proceeds by injecting test light from a light source into the PIC via an optical probe, allowing the test light to propagate through the photonic circuitry, and collecting the resulting output light for detection and analysis. This process is repeated for each of the *N* gap settings, with all other test conditions held constant. The resulting N measurement results, each exhibiting a distinct interference pattern due to the cavity effect, are then combined to produce a corrected measurement output with reduced probe-spacing artifacts.

The disclosed techniques provide a number of benefits. They enable accurate PIC characterization without requiring index-matching media, and they are well suited to wafer-scale, multi-die, and other high-throughput testing environments. They can be integrated into a variety of test platforms and adapted to a wide range of optical testing scenarios. By reducing measurement variability associated with small changes in probe-to-PIC spacing, the disclosed techniques improve repeatability and reliability. In some implementations, they may also assist in optical alignment by improving consistency in coupling conditions. The measurements can include optical insertion loss, return loss, and transmission or reflection spectra. In some implementations, single-value parameters such as average transmitted power or peak wavelength response can also be measured.

Additional aspects and example implementations are described below with reference to the accompanying figures.

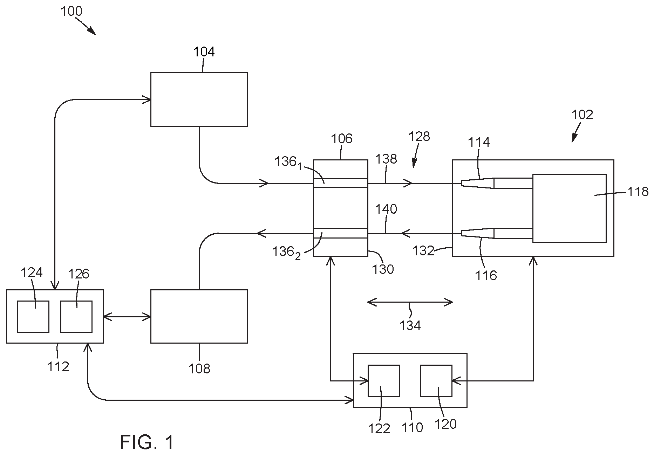

Referring to Fig. 1, an embodiment of a testing system 100 for characterizing a PIC 102 is illustrated. The testing system 100 includes a light source 104, an optical probe 106, an optical detector 108, an alignment stage 110, and a control and processing unit 112. In some implementations, the testing system 100 may be provided as a fully integrated, standalone PIC testing instrument. In other cases, the individual components may be manufactured and sold separately, allowing for modular assembly into a complete system. Hybrid configurations are also possible, in which only some components are integrated, while others are provided separately.

Further details regarding the structure, configuration, and operation of these components are provided below. It should be noted that Fig. 1 is a schematic representation intended to illustrate functional and structural aspects of the testing system 100. For clarity, certain auxiliary features or practical implementation details, such as those found in full test stations, may be simplified or omitted.

In the illustrated embodiment, the testing system 100 is configured for edge-coupling to the PIC 102. While the disclosed techniques may be particularly well suited for edge-coupled configurations, they may also be adapted for certain surface-coupling configurations in which cavity-induced interference effects may arise. One example includes surface coupling via normal-incidence surface couplers (e.g., grating couplers). In the edge-coupling configuration shown in Fig. 1, the PIC 102 includes an input edge coupler 114 that receives test light from the light source 104 via the optical probe 106, and an output edge coupler 116 that transmits measurement light from the PIC 102 to the optical detector 108, also via the optical probe 106. The edge couplers 114, 116 may take various forms, including tapered, inverse-tapered, metamaterial-based, multi-layer, suspended, or vertical edge couplers, each offering specific benefits. These structures are generally known in the art and need not be described in detail except as necessary to understand the present techniques.

The PIC 102 further includes a set of interconnected photonic components 118 forming the functional circuitry of the device. These components 118 are optically coupled between the input and output edge couplers 114, 116, and may include passive and active optical elements such as waveguides, splitters, combiners, modulators, interferometers, switches, and on-chip sources and detectors. Together, these elements define the behavior and function of the PIC 102 during testing. The PIC 102 may be implemented on various material platforms, including silicon-on-insulator, indium phosphide, silicon nitride, lithium niobate, and gallium arsenide. The testing system 100 may be configured to characterize various PIC formats, including full wafer, wafer bar, and single-die or multi-die configurations, depending on the fabrication stage or testing objective. As the general structure, materials, and fabrication methods for PICs are well established, a detailed description of the internal layout of the PIC 102 is omitted except as necessary to understand the present techniques.

The light source 104 can be embodied by any appropriate device or combination of devices capable of generating test light suitable for PIC characterization, including both narrowband and broadband sources. In some embodiments, the test light can have a bandwidth lying within a waveband ranging from about 1260 nm to about 1680 nm (e.g., encompassing the O, E, S, C, L, and U telecom wavelength bands in the short-wavelength infrared). However, this spectral range is illustrative and not limiting, as the disclosed techniques may be applicable across the visible, near-infrared, and mid-infrared spectra as well.

In some embodiments, the light source 104 can be a laser source, such as a high-power continuous-wave tunable laser source with a narrow linewidth and high-resolution tunability. Tunable laser sources allow for continuous adjustment of the laser wavelength over a certain range, enabling testing of the PIC 102 at various operating wavelengths. Non-limiting examples of laser sources include solid-state lasers (e.g., bulk crystal lasers and fiber lasers) and semiconductor lasers (e.g., laser diodes). However, non-laser sources are also possible, including light-emitting diode (LED) sources, amplified spontaneous emission (ASE) sources, and semiconductor optical amplifier (SOA) sources. The light source 104 may also include or be used with conditioning optics (e.g., filters, lenses, or amplifiers) configured to condition the source light before it is delivered to the PIC 102.

The optical probe 106 may include any suitable coupling device or combination of devices capable of establishing bidirectional optical communication with the PIC 102. In some embodiments, the probe 106 includes an optical fiber array configured to align with PIC's edge couplers 114, 116. The probe's fiber array may include any suitable number of individual optical fibers 136₁, 136₂ (e.g., 2, 4, 8, or 16), depending on the PIC configuration or the testing setup. For example, in Fig. 1, one fiber 136₁ may be aligned with the input edge coupler 114 of the PIC 102 to deliver test light 138 from the light source 104, while another fiber 136₂ may be aligned with the output edge coupler 116 to collect the measurement light 140 and direct it to the optical detector 108. The individual fibers 136₁, 136₂ may be single-mode or multimode. Parameters such as fiber composition and geometry, refractive index profile, numerical aperture, polarization control, and spectral compatibility can be customized based on specific application needs.

While optical fiber arrays are commonly used in PIC testing, other types of optical waveguides or couplers (e.g., photo-inscribed or free-form waveguides) may also be employed in the optical probe 106, depending on the testing platform and coupling interface. In certain setups, the probe 106 may be implemented as a single unit for both injection and collection. In other cases, the probe 106 may include distinct injection and collection components, with the former coupled between the light source 104 and the input edge coupler 114, and the latter coupled between the output edge coupler 116 and the optical detector 108.

The optical detector 108 may include any suitable photodetector or combination of photodetectors capable of measuring optical power within the spectral range of the measurement light 140 received from the PIC 102. Suitable technologies include PIN photodiodes, avalanche photodiodes, and Schottky photodiodes. The optical detector 108 converts the received light 140 into electrical signals representative of its optical characteristics. Detector selection can be based on parameters such as power levels, spectral range, sensitivity, and response time. In some embodiments, the optical detector 108 may be a non-spectrally resolved detector (e.g., an optical power meter), providing a single-value measurement averaged over the spectral bandwidth of the measurement light 140 or the detector's sensitivity range, whichever is narrower. In such cases, a spectral response of the PIC 102 may still be reconstructed by varying the test light's wavelength (e.g., using a tunable narrowband light source) and recording the resulting optical power at each wavelength. In other embodiments, the optical detector 108 may be a spectrally resolved detector capable of directly measuring wavelength-dependent responses. Such detectors may include optical spectrum analyzers (OSAs), swept-wavelength systems, or other wavelength-selective devices. These detectors may be used in conjunction with broadband sources, such as superluminescent LED (SLED) or ASE sources, to acquire a spectrally resolved response of the PIC 102.

The alignment stage 110 is configured to enable precise relative positioning between the PIC 102 and the optical probe 106, ensuring accurate optical coupling and alignment during testing. Depending on the application, the alignment stage 110 includes: a PIC positioning unit 120 configured to adjust the position of the PIC 102 while the probe 106 remains stationary; a probe positioning unit 122 configured to adjust the position of the probe 106 while the PIC 102 remains stationary; or both a PIC positioning unit 120 and a probe positioning unit 122, allowing for coordinated adjustments. Each unit 120, 122 may be independently actuated (e.g., using precision motors or other actuators) and may offer both translational positioning (e.g., along one, two, or three axes) and rotational positioning (e.g., about one, two, or three axes). For example, the PIC positioning unit 120 may provide four degrees of freedom, three translations and one rotation about an axis perpendicular to the PIC plane, while the probe positioning unit 122 may offer six degrees of freedom. Step size resolution may vary depending on the stage design, but can typically reach sub-micrometer levels (e.g., 100 nm or less). Common actuation technologies include piezoelectric actuators, stepper motors, and voice coil drives. The alignment stage 110 may accommodate various PIC formats and may support either manual or automated alignment procedures. Alignment stages suitable for PIC testing are well known in the art and need not be described in further detail except as necessary to understand the present techniques.

The control and processing unit 112 is operatively coupled to various components of the testing system 100, including the light source 104, optical detector 108, and alignment stage 110. The control and processing unit 112 includes one or more processors 124 and one or more memories 126, implemented in hardware, software, firmware, or any combination thereof. The control and processing unit 112 may be fully or partially integrated with other system components (e.g., the optical detector 108, in configurations where it primarily performs signal processing), or implemented as a physically separate module.

In addition to signal processing (e.g., converting electrical signals from the optical detector 108 into test results), the control and processing unit 112 may coordinate hardware operations, including the positioning of the alignment stage 110 and the control of the light source 104. This allows for full or partial automation of testing operations. The control and processing unit 112 may support wired or wireless communication with system components and may be operated through direct user input and/or programmed instructions. In some implementations, the control and processing unit 112 may interact with a user interface including input/output devices (e.g., touchscreens, buttons, displays), and may optionally utilize distributed or cloud-based computing resources for data processing or storage.

Referring still to Fig. 1, the optical configuration during edge-coupled testing gives rise to an FP cavity 128 between the optical probe 106 and the PIC 102. This cavity 128 is defined by two partially reflective interfaces: a probe-side interface 130 (e.g., a fiber facet) and a PIC-side interface 132 (e.g., a PIC facet). The intervening region, typically air, between these interfaces 130, 132 defines the cavity length 134, also referred to herein as the measurement gap or alignment gap. Multiple internal reflections within this region produce resonant interference effects, modulating the effective transmission through the cavity 128 as a function of both wavelength and cavity length. The resulting spectral response, as measured by the optical detector 108, exhibits periodic constructive and destructive interference patterns, governed by the round-trip optical phase delay within the cavity. Insertion loss measurements may therefore be affected by such cavity-induced effects, leading to systematic position-sensitive errors during PIC testing.

The transmission function T through an FP cavity formed by two parallel interfaces may be described by the following equation: $T = \frac{{T}_{1} {T}_{2}}{1 + {R}_{1} {R}_{2} - 2 \sqrt{{R}_{1} {R}_{2}} cos δ} ,$ (1) where *T*₁*, R*₁ are the transmission and reflection coefficients at the probe-side interface 130, *T*₂*, R*₂ are those at the PIC-side interface 132, and *δ* is the round-trip optical phase shift experienced by light traveling through the cavity 128. For normal incidence, this phase shift is given by: $δ = \frac{4 πnd}{λ} ,$ (2) where *n* is the refractive index of the medium in the gap (typically *n* ≈ 1 for air), *d* is the cavity length, and *λ* is the free-space wavelength.

To assess the impact of cavity-induced errors, the transmission function in Eq. (1) can be expanded as a Taylor series around cos*δ* = 0: $T \approx \frac{{T}_{1} {T}_{2}}{1 + {R}_{1} {R}_{2}} \left[1+\left(\frac{2 \sqrt{{R}_{1} {R}_{2}}}{1 + {R}_{1} {R}_{2}}\right)cosδ+{\left(\frac{2 \sqrt{{R}_{1} {R}_{2}}}{1 + {R}_{1} {R}_{2}}\right)}^{2}{cos}^{2}δ+⋯\right] .$ (3)

For illustration, assuming both interfaces 130, 132 are air-silica boundaries with *n*ₐᵢᵣ ≈ 1 and *n*_{silica} ≈ 1.44, the reflection coefficient at normal incidence becomes: ${R}_{1} = {R}_{2} = {\left|\frac{{n}_{silica} - {n}_{air}}{{n}_{silica} + {n}_{air}}\right|}^{2} \approx 0.033 ,$ (4) which yields *T*₁ *= T*₂ *≈* 0.967. Substituting these values into Equation (3), the transmission function becomes: $T \approx 0.935 \left(1+0.065 cosδ+0.004 {cos}^{2}δ+⋯\right) .$ (5)

The first-order term introduces a periodic modulation in the transmission function, with an amplitude of up to 10log(1 + 0.065) ≈ 0.27 dB. This modulation is non-negligible, as it can measurably affect insertion loss measurements in typical test conditions. Additionally, quantitative determination or prediction of this error is challenging without precise knowledge, on the scale of a fraction of the half wavelength, of the probe-to-PIC gap at both the injection and collection ports. Meanwhile, the second-order term contributes up to 10log(1 + 0.004) ≈ 0.017 dB, which is generally negligible in comparison. The present techniques therefore focus on suppressing this dominant first-order term.

This suppression is achieved using the N-step measurement technique introduced earlier. For illustration, the case *N* = 2 is considered. Two test measurements are performed such that the associated round-trip optical phase shifts *δ* and *δ*' differ by an odd multiple of *π*, that is, $δ - δ ′ = \left(2m+1\right) π , m ∈ ℤ .$ (6)

From Eq. (2), this phase shift condition translates into a gap change Δ*d* given by: $Δ d = \left(2m+1\right) \frac{{λ}_{design}}{4 n} ,$ (7) where *λ*_{design} is selected as a representative design wavelength within the operating spectrum of the PIC 102 under test (e.g., near its center for balanced suppression across the band). With this condition, the transmission functions for the two measurements are: $\begin{matrix}T \approx 0.935 \left(1+0.065 cosδ+0.004 {cos}^{2}δ+⋯\right) , \\ T ′ \approx 0.935 \left(1-0.065 cosδ+0.004 {cos}^{2}δ+⋯\right) .\end{matrix}$ (8)

Averaging these two results yields: ${T}_{mean} = \frac{T + T ′}{2} \approx 0.935 \left(1+0.004 {cos}^{2}δ+⋯\right) .$ (9) Thus, the first-order term is canceled, and only the higher-order terms remain, which are much smaller. This averaging substantially suppresses the dominant cavity-induced modulation in the transmission function.

This approach can be extended to cases where *N >* 2 by selecting measurement probe-to-PIC distance values that produce N round-trip optical phase shifts that are spaced substantially evenly over a full 2*π* cycle. For example, with N= 3, the phase shifts would be spaced by 2π/3 to provide complementary interference conditions, while they would be spaced by π/2 with *N=* 4. When the *N* test measurements are suitably combined, the first-order error term can be effectively suppressed. As used herein, "spaced substantially evenly" refers to phase spacings that are sufficiently uniform to ensure that the contributions from the N test measurements counteract or average out cavity-induced modulation, such that any residual error is negligible, not practically significant, or reduced enough to yield a meaningful improvement in measurement accuracy.

It is noted that the selected distance values need not be minimally spaced, since the round-trip optical phase is periodic modulo 2*π*, allowing equivalent phase shifts to be obtained at multiple absolute gap values. This flexibility enables the use of larger gap differences across the N measurements. For example, the minimal quarter-wavelength gap difference for *N* = 2 may not be achievable in certain setups, but larger odd-multiple intervals, such as 3*λ*/4 or 5*λ*/4, would still satisfy the phase requirements.

It is also noted that the first-order term is fully suppressed only at the design wavelength *λ*_{design}. Away from this wavelength, a residual error remains and can be expressed, for the case *N =* 2 with an air gap and a quarter-wavelength gap change *λ*_{design}/4, as: $\begin{matrix}Δ T \left(λ\right) = 0.935 \left\{0.065 cos\left(\frac{4 πd}{λ}\right)+0.065 cos\left[\frac{4 π}{λ}\left(d+\frac{{λ}_{design}}{4}\right)\right]\right\} \\ = 0.935 \left\{0.130 cos\left[\frac{4 π}{λ}\left(d+\frac{{λ}_{design}}{8}\right)\right]cos\left(\frac{{πλ}_{design}}{2 λ}\right)\right\} .\end{matrix}$ (10) This residual first-order error vanishes when *λ*_{design} = *λ*, but remains generally small for representative values. For example, for a spectrum extending from 1505 nm to 1675 nm with *λ*_{*d*esign} = 1600 nm (as in the experimental results reported below), the maximum values of the residual errors, reached at the spectrum endpoints, are on the order of 0.05 dB.

Furthermore, by combining multiple measurements with phase-complementary conditions, not only the cavity effect in the PIC-probe gap can be reduced, but also cavity effects in other segments of the optical testing path that may form unintended FP cavities. This includes reflections between fiber connections, fiber ends, and photonic waveguide elements. Because these parasitic cavities also produce interference patterns sensitive to small positional variations, applying the phase-shifted measurement techniques disclosed herein can help reduce their impact.

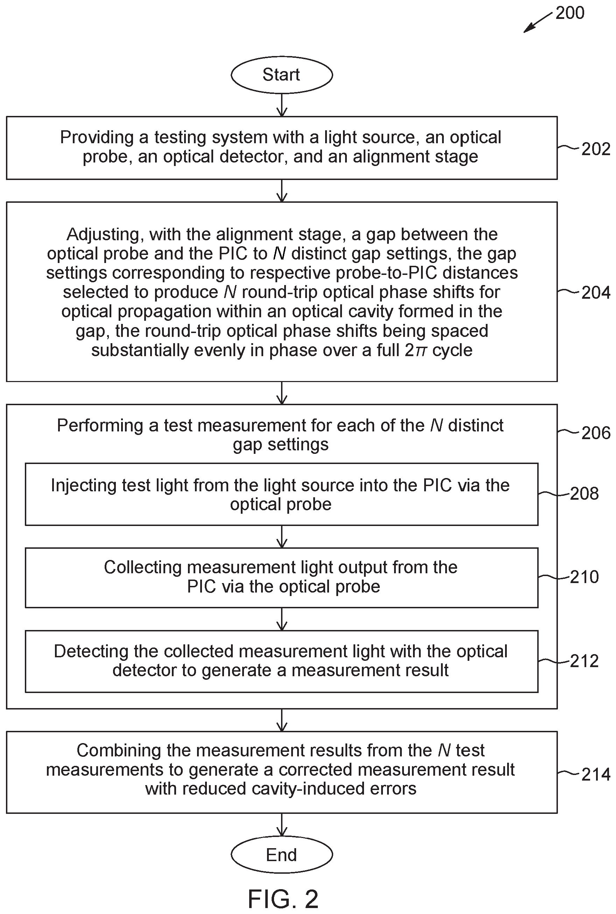

Operational aspects of the present techniques will now be described in greater detail with reference to Fig. 2, which depicts a flow diagram of a method 200 for mitigating position-sensitive errors during PIC testing.

The method 200 includes a step 202 of providing a testing system including a light source, an optical probe, an optical detector, and an alignment stage. These components may correspond, for example, to those of the testing system 100 shown in Fig. 1 or any other suitable systems configured for optical testing of PICs. The testing system is configured to enable optical coupling between the light source and the PIC via the optical probe, and to collect measurement light from the PIC for detection by the optical detector.

The method further includes a step 204 of adjusting, with the alignment stage, the measurement gap between the optical probe and the PIC to N distinct gap settings. These gap settings correspond to respective probe-to-PIC distances selected to produce N round-trip optical phase shifts for optical propagation within an FP cavity formed in the gap, with the round-trip optical phase shifts being spaced substantially evenly in phase over a full 2*π* cycle. Depending on the implementation, the adjustment of the probe-to-PIC distance between measurements can be achieved by moving the probe with respect to the PIC, by moving the PIC with respect to the probe, or by moving both. For *N* = 2, the cavity length may be adjusted by an odd multiple of a quarter of the design wavelength *λ*_{design}, resulting in phase shifts differing by *π*. Higher values of *N* (e.g., 3 or 4) and corresponding values of cavity length shifts (e.g., *λ*_{design}/6 or *λ*_{design}/8 for an air gap) may be used in other embodiments based on setup or time constraints. The cavity length adjustments may be automated and performed under software control to ensure consistency and repeatability.

At each of the gap settings, the method 200 includes a step 206 of performing a test measurement that includes the following operations: injecting 208 test light from the light source into the PIC via the optical probe; collecting 210 measurement light output from the PIC via the optical probe; and detecting 212 the collected measurement light with the optical detector to generate a measurement result. In practice, this involves the light source emitting test light, which is delivered to an input edge coupler of the PIC. The measurement light exiting the PIC is collected by the probe and directed to the optical detector. The same test conditions are maintained for each of the N test measurements except for the probe-to-PIC gap. This ensures that variations in the measurement results are attributable primarily to phase-sensitive effects in the cavity, rather than to changes in the device or testing setup.

The method 200 continues with a step 214 of combining the measurement results from the N test measurements to generate a corrected measurement result with reduced position-sensitive errors induced by the optical cavity. In the case of *N* = 2, the results from the pair of measurements are averaged to cancel the first-order FP interference term. For larger N, the measurement results are combined using a suitable averaging or weighted summation procedure that achieves destructive interference of cavity-induced modulation across the phase-spaced measurements.

Experimental studies were conducted to assess and validate different aspects of the present techniques. It is appreciated that the following description presents specific implementations of the underlying principles and is not intended to be limiting, as the disclosed techniques allow for numerous variations in implementation and application.

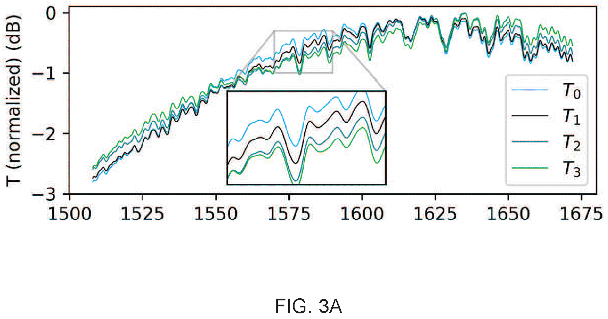

A series of insertion loss measurements were performed on a PIC by sweeping a tunable laser over a 170 nm spectral range, from 1505 nm to 1675 nm. Between each measurement, a fiber array probe was shifted by 100 nm along its optical axis to vary the FP cavity length between the probe and the PIC. This produced a set of 20 measurements spanning a total range of 2 µm. Fig. 3A presents four representative insertion loss spectra (*T*₀*, T*₁, *T₂*, *T*₃) obtained under these conditions. Although a Gaussian filter was applied to suppress highfrequency noise, significant fluctuations remained in the raw data, primarily attributed to polarization-dependent variations in the automated optical switch feeding test light into the fiber array. Despite this residual noise, modulation induced by the FP cavity is clearly visible across the individual measurements (see inset, where the spectra are vertically offset, from top to bottom, as *T*₀, *T*₁, *T*₂*,* and T₃), with spectral variations in insertion loss reaching up to 0.3 dB. The fact that these four spectra, acquired under nominally identical conditions except for probe-to-PIC spacing, exhibit noticeably different ripple features highlights the sensitivity of conventional, single-point measurements to cavity effects and positional variation.

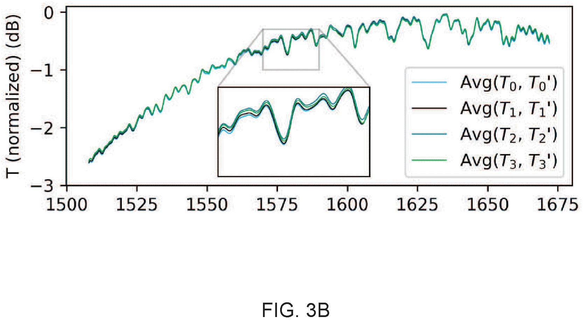

Fig. 3B presents four insertion loss spectra (Avg(*T*₀, *T*₀'), Avg(*T*₁, *T*₁'), Avg(*T*₂, *T*₂'), Avg(*T*₃, *T*₃')) obtained using the disclosed phase-shifted measurement techniques with N = 2. Each spectrum was constructed by averaging a pair of single-distance measurements (selected from the same 20 used to generate Fig. 3A). The two measurements in each pair were separated by a 400-nm probe-to-PIC gap offset, corresponding to a round-trip phase difference of *π* for a design wavelength *λ*_{design} of 1600 nm. These paired measurements effectively cancel the dominant cavity-induced ripples, as the *π*-shifted interference patterns within each pair destructively interfere. As shown in the inset, the four corrected spectra are nearly superimposed, exhibiting markedly reduced position-dependent modulation compared to the single measurement spectra of Fig. 3A. These results indicate that the disclosed techniques can substantially reduce cavity-induced measurement artifacts while preserving the underlying spectral features of the PIC's response.

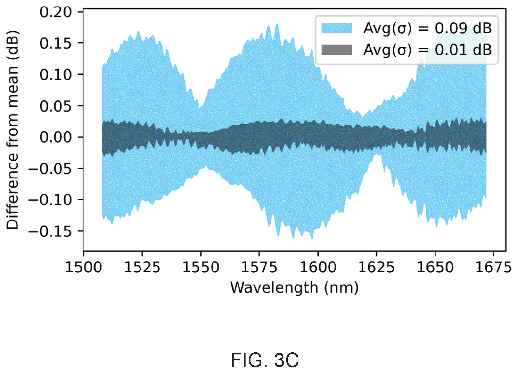

Fig. 3C quantifies this improvement by plotting the envelope of spectral variation around the mean for each case. The uncorrected single-measurement data (light-colored data; from Fig. 3A) exhibits a wide error band, whereas the corrected data (dark-colored data; from Fig. 3B) shows a significantly narrower envelope. On average, the standard deviation of the insertion loss measurements is reduced from approximately 0.09 dB to 0.01 dB, resulting in nearly an order-of-magnitude improvement in measurement precision using the disclosed dual-measurement, phase-complementary approach.

In the present description, similar features in the drawings have been given similar reference numerals. To avoid cluttering certain figures, some elements may not be indicated if they were already identified in a preceding figure. The elements of the drawings are not necessarily depicted to scale since emphasis is placed on clearly illustrating the elements and structures of the present embodiments. Positional descriptors indicating the location and/or orientation of one element with respect to another element are used herein for ease and clarity of description. Unless otherwise indicated, these positional descriptors should be taken in the context of the figures and should not be considered limiting. In particular, positional descriptors are intended to encompass different orientations in the use or operation of the present embodiments, in addition to the orientations exemplified in the figures. Furthermore, when a first element is referred to as being "on," "above," "below," "over," or "under" a second element, the first element can be either directly or indirectly on, above, below, over, or under the second element, respectively, such that one or multiple intervening elements may be disposed between the first element and the second element.

The terms "a," "an," and "one" are defined herein to mean "at least one," that is, these terms do not exclude a plural number of elements, unless stated otherwise.

The term "or" is defined as "and/or," unless stated otherwise.

Terms such as "substantially," "generally," and "about," which modify a value, condition, or characteristic should be understood to mean that the value, condition, or characteristic falls within acceptable tolerances for the proper functioning of the described embodiment or within an acceptable range of experimental error. In particular, the term "about" generally denotes a range of values that one skilled in the art would consider equivalent to the stated value (e.g., having the same or an equivalent function or result). In some instances, the term "about" means a variation of ±10% of the stated value. It is noted that all numeric values used herein are assumed to be modified by the term "about," unless stated otherwise. The term "between" refers to a range defined by endpoints, inclusive of both endpoints, unless stated otherwise.

The term "based on" as used herein is intended to mean "based at least in part on," whether directly or indirectly, and to encompass both "based solely on" and "based partly on." In particular, the term "based on" may also be understood as meaning "from," "depending on," "representative of," "indicative of," "associated with," "relating to," and the like.

The terms "match," "matching," and "matched" refer herein to a condition where two elements are either identical or within a predetermined tolerance of each other. These terms encompass not only exact matches but also substantial, approximate, or subjective matches, as well as a best or highest match among various matching possibilities.

The terms "connected" and "coupled," along with their derivatives and variants, refer herein to any form of connection or coupling, whether direct or indirect, between two or more elements, unless stated otherwise. This connection or coupling can take various forms, including, but not limited to, mechanical, optical, electrical, magnetic, thermal, chemical, logical, fluidic, operational, or any combination thereof.

The term "concurrently" refers herein to the simultaneous or overlapping occurrence of two or more processes. The term "concurrently" does not necessarily imply complete synchronicity but encompasses various scenarios. These scenarios include the simultaneous occurrence of two processes; a first process that both begins and ends during the duration of a second process; and a first process that starts during the duration of a second process but ends after the second process is completed.

The term "measured" when referring to a quantity or parameter is intended to mean that the quantity or parameter can be measured either directly or indirectly. In the case of indirect measurement, the quantity or parameter can be derived, retrieved, inferred, or otherwise determined from directly measured data.

The terms "light" and "optical," along with their variants and derivatives, encompass radiation across any appropriate region of the electromagnetic spectrum. This includes not only visible light but also extends to invisible regions such as the terahertz (THz), infrared (IR), and ultraviolet (UV) spectral bands. Furthermore, all descriptions provided herein as a function of wavelength could also be formulated as a function of frequency, wave number, energy, or other pertinent spectral parameters.

The term "processor" as used herein broadly refers to any electronic device, circuitry, or component capable of processing, receiving, or transmitting data or instructions, such as computer programs, commands, functions, processes, software codes, executables, applications, and similar entities. The term "processor" is meant to encompass a single processor or processing unit, multiple processors or processing units, or other suitably configured processing elements. When a processor includes multiple processing elements, the processing elements may be located at a single site or distributed across multiple sites interconnected by a communication network. Examples of communication networks include local area networks (LANs) and wide area networks (WANs) such as the Internet. Non-limiting examples of processors include general-purpose single- or multi-core processors; central processing units (CPUs); microprocessors; controllers; microcontrollers; digital signal processors (DSPs); programmable logic devices; a field-programmable gate arrays (FPGAs); application-specific integrated circuits (ASICs); digital processors or circuits; analog processors or circuits; state machines; and/or any other device capable of processing information.

The term "memory" as used herein broadly refers to any electronic device, circuitry, or component capable of storing electronic data or information. In some instances, the term "memory" may be used interchangeably with the term "computer readable storage medium." The term "memory" is meant to encompass a single memory or memory unit, multiple memories or memory units, or other suitably configured memory elements. When a memory includes multiple memory elements, these elements may be located at a single site or distributed across multiple sites interconnected by a communication network. Non-limiting examples of memories include random-access memories (RAM) of any type; read-only memories (ROM) of any type; magnetic storage devices; optical storage devices; solid-state drive (SSD) devices, such as flash drive memories; and any other tangible and/or non-transitory computer readable medium capable of storing electronic data or information.

Numerous modifications could be made to the embodiments described above without departing from the scope of the appended claims.

## Claims

1. A method (200) for mitigating position-sensitive errors during testing of a photonic integrated circuit (PIC) (102), the method (200) comprising:
providing (202) a testing system (100) comprising a light source (104), an optical probe (106), an optical detector (108), and an alignment stage (110);
adjusting (204), with the alignment stage (110), a gap between the optical probe (106) and the PIC (102) to *N* distinct gap settings, wherein *N* ≥ 2, the gap settings corresponding to respective probe-to-PIC distances selected to produce N round-trip optical phase shifts for optical propagation within an optical cavity (128) formed in the gap, the round-trip optical phase shifts being spaced substantially evenly in phase over a full 2*π* cycle;
for each of the N distinct gap settings, performing (206) a test measurement comprising:
injecting (208) test light (138) from the light source (104) into the PIC (102) via the optical probe (106);
collecting (210) measurement light (140) output from the PIC (102) via the optical probe (106); and
detecting (212) the collected measurement light (140) with the optical detector (108) to generate a measurement result; and
combining (214) the measurement results from the N test measurements to generate a corrected measurement result with reduced position-sensitive errors induced by the optical cavity (128).

2. The method (200) of claim 1, comprising coupling the optical probe (106) with the PIC (102) in an edge-coupled configuration.

3. The method (200) of claim 1 or 2, comprising providing the optical probe (106) as an optical fiber array (136₁, 136₂).

4. The method (200) of any one of claims 1 to 3, wherein *N =* 2, and adjusting (204) the gap between the optical probe (106) and the PIC (102) comprises setting the two probe-to-PIC distances to differ by approximately a quarter wavelength of the test light (138) at a design wavelength.

5. The method (200) of any one of claim 1 to 4, wherein the measurement results correspond to insertion loss spectra of the PIC (102), measured at the N gap settings.

6. The method (200) of claim 5, wherein the insertion loss spectra are acquired over a waveband that lies within a spectral range from about 1260 nm to about 1680 nm.

7. The method (200) of any one of claims 1 to 6, wherein the method (200) is implemented with the PIC (102) provided in a wafer-level or multi-die test configuration.

8. The method (200) of any one of claims 1 to 7, wherein combining (214) the measurement results comprises computing an average of the measurement results from the *N* test measurements.

9. A testing system (100) for testing a photonic integrated circuit (PIC) (102) with reduced position-sensitive errors, the testing system (100) comprising:
a light source (104) configured to generate test light (138);
an optical probe (106) configured to couple the test light (138) from the light source (104) into the PIC (102) and collect measurement light (140) output from the PIC (102);
an optical detector (108) configured to detect the collected measurement light (140);
an alignment stage (110) configured to adjust a gap between the optical probe (106) and the PIC (102) to *N* distinct gap settings over a series of *N* test measurements, wherein *N* ≥ 2, the gap settings corresponding to respective probe-to-PIC distances selected to produce N round-trip optical phase shifts for optical propagation within an optical cavity (128) formed in the gap, the round-trip optical phase shifts being spaced substantially evenly in phase over a full 2*π* cycle; and
a control and processing unit (112) coupled to the optical detector (108) and configured to:
receive, for each one of the N test measurements, a corresponding measurement result from the optical detector (108); and
combine the N measurement results to generate a corrected measurement result with reduced position-sensitive errors induced by the optical cavity (128).

10. The testing system (100) of claim 9, wherein the optical probe (106) is configured to couple with the PIC (102) in an edge-coupled configuration.

11. The testing system (100) of claim 9 or 10, wherein the optical probe (106) comprises an optical fiber array (136₁, 136₂).

12. The testing system (100) of any one of claims 9 to 11, wherein *N= 2,* and the alignment stage (110) is configured to set the two probe-to-PIC distances to differ by approximately a quarter wavelength of the test light (138) at a design wavelength.

13. The testing system (100) of any one of claims 9 to 12, wherein the measurement results correspond to insertion loss spectra of the PIC (102), measured at the *N* gap settings.

14. The testing system (100) of any one of claims 9 to 13, wherein the light source (104) comprises a tunable laser.

15. The testing system (100) of any one of claims 9 to 14, wherein the control and processing unit (112) is configured to compute an average of the measurement results from the N test measurements to generate the corrected measurement result.
